# EUROPEAN PATENT APPLICATION

(11) **EP 4 660 603 A1**
(43) Date of publication of application: **10.12.2025**
(21) Application number: 25181380.4
(22) Date of filing: 06.06.2025
(51) Int. Cl.: G01M 5/00, B64F 5/60, G01M 7/08, G01M 7/02

(54) **COMPOSITE TANK STRUCTURAL INTEGRITY EVALUATION SYSTEM**

(30) Priority: 07.06.2024 US 202418737071
(71) Applicant: PRATT & WHITNEY CANADA CORP., Longueuil, Québec J4G 1A1 (CA)
(72) Inventor: BOSSE, Alexandre, Longueuil (CA); JOSHI, Ninad, Brampton (CA)
(74) Representative: Dehns

(57) **Abstract**

A structural integrity evaluation system for a tank made of a composite material, has: an excitor connected to the tank for inducing a stimulus to the tank; sensors connected to the tank, the sensors including a structural integrity sensor for sensing characteristics of a response of the tank and an operating condition sensor for sensing operating conditions; a controller operatively connected to the excitor and to the sensors and configured to: cause the excitor to induce the stimulus to the tank; obtain the response of the tank to the stimulus; determine a structural state of the tank by feeding the characteristics of the response to the stimulus and the operating conditions to a trained model; and in response to a determination that the structural state of the tank is indicative of an adverse condition, issue an alert indicative that a mitigation action is to be performed on the tank.

## Description

### TECHNICAL FIELD

The application relates generally to aircraft engines and, more particularly, to systems and methods used to evaluate the integrity of composite tanks that carry fluids used by such engines.

### BACKGROUND

Aircrafts use tanks to carry fluids, such as fuel, lubricant, and so on. In order to ensure the structural integrity of these tanks, periodic inspections of the tanks are typically conducted, using a variety of inspection methods. While existing inspection methods are satisfactory for their intended purposes, improvement is always sought.

### SUMMARY

According to a first aspect, there is provided a structural integrity evaluation system for a tank made of a composite material, the composite material including fibers embedded in a matrix, comprising: an excitor operatively connected to the tank and configured for inducing a stimulus to the tank; sensors operatively connected to the tank, the sensors including a structural integrity sensor for sensing characteristics of a response of the tank to the stimulus generated by the excitor and an operating condition sensor for sensing operating conditions in which the tank is being used; a controller operatively connected to the excitor and to the sensors, the controller having a processing unit and a computer-readable medium having stored thereon instructions executable by the processing unit to: cause the excitor to induce the stimulus to the tank; obtain, from the structural integrity sensor, the response of the tank to the stimulus; determine a structural state of the tank by feeding the characteristics of the response to the stimulus and the operating conditions to a trained model, the trained model having been trained using machine learning and training data, the training data including characteristic data sets and operating conditions data sets associated with structural states data sets; and in response to a determination that the structural state of the tank is indicative of an adverse condition, issue an alert indicative that a mitigation action is to be performed on the tank.

The structural integrity evaluation system described above and elsewhere herein may also include any one or more of the following features, in whole or in part, and in any combination.

In some embodiments, the stimulus includes vibrations, the characteristics of the response includes one or more of an amplitude, a frequency, a damping coefficient, and a phase of the response.

In some embodiments, the characteristics of the response further include one or more of a structural damping of the response as a function of time, frequency response functions defined as ratios of responses to stimuli as function of stimulation frequencies of the stimuli, and damping coefficients associated with the stimulation frequencies.

In some embodiments, the sensors include at least one structural sensor for sensing the characteristics of the response of the tank to the stimulus, the at least one structural sensor including one or more of an accelerometer, a strain gauge, a semiconductor strain gauge, an ultrasonic detector, a dynamic pressure transducers, and an eddy current sensor.

In some embodiments, the sensors include at least one operating condition sensor for sensing the operating conditions of the tank, the at least one operating condition sensor including one or more of a temperature sensor for determining a temperature of the tank, a first pressure sensor for determining a pressure of an environment outside the tank, a second pressure sensor for determining an inside pressure inside the tank, and a level sensor for determining a level of a fluid in the tank.

In some embodiments, mitigation action is one or more of a replacement of the tank, an inspection of the tank, and a repair procedure to the tank.

In some embodiments, the computer-readable medium further has instructions executable by the processing unit to determine that the structural state of the tank is indicative of the adverse condition by determining that the structural state presents one or more of broken fibers, delamination, debonding, cracks in the matrix, wrinkles, resin richness, presence of a foreign object, presence of a void, presence of a blister, porosity.

According to a second aspect, there is provided an aircraft comprising the tank and the structural integrity evaluation system described above, and the computer-readable medium further has instructions executable by the processing unit to determine the structural state of the tank while the tank is installed on the aircraft.

According to a third aspect, there is provided a method of mitigating an adverse condition of a structural integrity of a tank made of a composite material including fibers embedded in a matrix, comprising: receiving characteristics of a response to a stimulus provided to the tank; receiving data regarding operating conditions in which the tank is being used; determining a structural state of the tank by feeding the characteristics of the response to the stimulus and the operating conditions to a trained model, the trained model having been trained using machine learning and training data, the training data including characteristic data sets and operating conditions data sets associated with structural states data sets; and in response to a determination that the structural state of the tank is indicative of an adverse condition, issue an alert indicative that a mitigation action is to be performed on the tank.

The method described above and elsewhere herein may also include any one or more of the following features, in whole or in part, and in any combination.

In some embodiments, the stimulus includes vibrations, the receiving of the characteristics of the response includes one or more of an amplitude, a frequency, a damping coefficient, and a phase of the response.

In some embodiments, the receiving of the characteristics of the response further includes receiving one or more of a structural damping of the response as a function of time, frequency response functions defined as ratios of responses to stimuli as function of stimulation frequencies of the stimuli, and damping coefficients associated with the stimulation frequencies.

In some embodiments, the receiving of the characteristics of the response includes receiving the characteristics of the response from at least one structural sensor, the at least one structural sensor including one or more of an accelerometer, a strain gauge, a semiconductor strain gauge, an ultrasonic detector, a dynamic pressure transducer, a fiber optic sensor, and an eddy current sensor.

In some embodiments, the receiving of the data regarding the operating conditions includes receiving the data from at least one operating condition sensor, the at least one operating condition sensor including one or more of a temperature sensor for determining a temperature of the tank, a first pressure sensor for determining a pressure of an environment outside the tank, a second pressure sensor for determining an inside pressure inside the tank, and a level sensor for determining a level of a fluid in the tank.

In some embodiments, the method includes causing of the mitigation action to be performed on the tank by one or more of causing a replacement of the tank, scheduling an inspection of the tank, and scheduling a repair procedure to the tank.

In some embodiments, the determining that the structural state of the tank is indicative of the adverse condition includes determining that the structural state presents one or more of broken fibers, delamination, debonding, cracks in the matrix, wrinkles, resin richness, presence of a foreign object, presence of a void, presence of a blister, porosity.

According to a fourth aspect, there is provided a method of evaluating a structural integrity of a tank made of a composite material including fibers embedded in a matrix, comprising: inducing a stimulus to the tank and determining characteristics of a response of the tank to the stimulus; receiving data regarding operating conditions in which the tank is being used; and determining a structural state of the tank by feeding the characteristics of the response to the stimulus and the operating conditions to a trained model, the trained model having been trained using machine learning and training data, the training data including characteristic data sets and operating conditions data sets associated with structural states data sets.

The method described above and elsewhere herein may also include any one or more of the following features, in whole or in part, and in any combination.

In some embodiments, the inducing of the stimulus includes inducing vibrations to the tank, the determining of the characteristics of the response includes determining one or more of an amplitude, a frequency, a damping coefficient, and a phase of the response.

In some embodiments, the determining of the characteristics of the response further includes determining one or more of a structural damping of the response as a function of time, frequency response functions defined as ratios of responses to stimuli as function of stimulation frequencies of the stimuli, and damping coefficients associated with the stimulation frequencies.

In some embodiments, the determining of the characteristics of the response includes determining the characteristics of the response from at least one structural sensor, the at least one structural sensor including one or more of an accelerometer, a strain gauge, a semiconductor strain gauge, an ultrasonic detector, a dynamic pressure transducer, a fiber optic sensor, and an eddy current sensor.

In some embodiments, the receiving of the data regarding the operating conditions includes receiving the data from at least one operating condition sensor, the at least one operating condition sensor including one or more of a temperature sensor for determining a temperature of the tank, a first pressure sensor for determining a pressure of an environment outside the tank, a second pressure sensor for determining an inside pressure inside the tank, and a level sensor for determining a level of a fluid in the tank.

### BRIEF DESCRIPTION OF THE DRAWINGS

Certain aspects and embodiments of the invention will now be described in more detail with reference to the accompanying non-limiting figures, in which:
Fig. 1 is a three dimensional view of an aircraft;
Fig. 2 is a schematic view of a structural integrity evaluation system;
Fig. 3 is a schematic representation of training data used to train a trained model of the system of Fig. 2;
Fig. 4 is a flowchart illustrating steps of a method performed by the system of Fig. 2;
Fig. 5 is a flowchart illustrating steps of a method of mitigating an adverse condition of a structural integrity of a tank;
Fig. 6 is a flowchart illustrating steps of a method of evaluating the structural integrity of the tank; and
Fig. 7 is a schematic representation of a controller for the system of Fig. 2.

### DETAILED DESCRIPTION

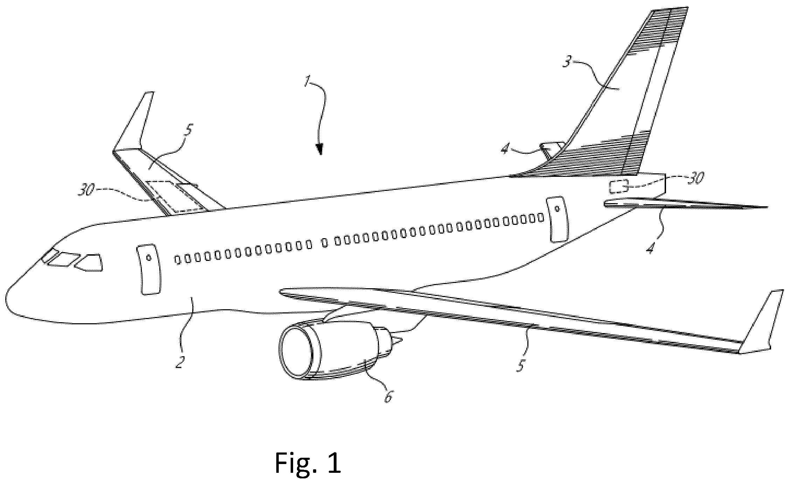

Fig. 1 illustrates an aircraft at 1 including a fuselage 2, a vertical stabilizer 3, a horizontal stabiliser 4, and wings 5. The aircraft 1 is equipped with two aircraft engines 6. The aircraft engines 6 may be thermal engines (e.g., gas turbine engines), hybrid electric engines, or other suitable aircraft powerplants. In the case of gas turbine engines, each engine may include, in serial flow communication, a fan through which ambient air is propelled, a compressor section for pressurizing the air, a combustor in which the compressed air is mixed with fuel and ignited for generating an annular stream of hot combustion gases, and a turbine section for extracting energy from the combustion gases. The fan, the compressor section, and the turbine section are rotatable about a central axis of the gas turbine engine. The aircraft 1 and/or the aircraft engines 6 may be equipped with one or more tanks 30 which contain a fluid used by the aircraft 1 or the aircraft engines 6, such as fuel tanks, lubricant tanks, and so on. In the case of fuel tanks, a tank 30 may be located, for instance, within the wings 5 of the aircraft 1. Only one tank is shown with dashed lines in Fig. 1, but it is to be appreciated that both wings 5 may contain one or more tank. The fuselage 2 may also contain a tank as shown in Fig. 1.

The tank 30 may be fluidly connected to the aircraft engines 6. The tank 30 may be a fuel tank fluidly connected to fuel nozzles of the aircraft engines 6 via suitable fluid line(s) and manifold(s). The tank 30 may alternately be a tank used to carry any fluid required for operation of the aircraft engine 6 such as lubricant (e.g., oil), and as such in certain embodiment the tank 30 may form part of the aircraft engine 6.

The tank 30 may be made of a composite material. In the context of the present disclosure, the expression "composite material" implies a mixture of fibers held together with a matrix. The fibers may be, for instance, glass fibers, aramid fibers, carbon fibers, any combinations thereof, and so on. The matrix may be, for instance, epoxy, a polymer, any combinations thereof and so on. In some cases, it is required to perform periodic inspections of the tank 30 to ensure its structural integrity is maintained over time. However, these inspections are time consuming, expensive, and cumbersome depending on the inspection methodology used. In other words, structural integrity may be evaluated using multiple inspection methodologies, which can result in aircraft downtime thus heavy associated maintenance cost.

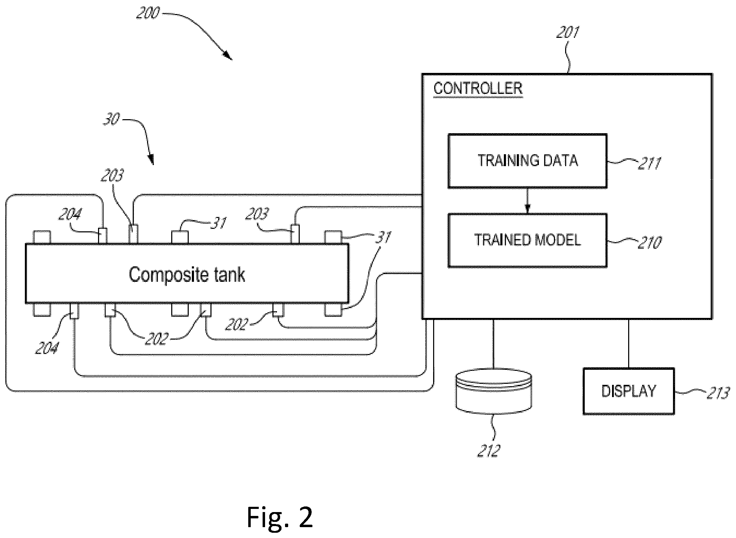

Referring to Fig. 2, a structural integrity evaluation system is shown at 200. The system 200 is operable to detect and characterize early stages of structural changes in the tank 30 that may lead to structural weakening. The system 200 is configured to excite the structure of the tank 30 and measure its structural responses to this excitation. The responses are categorized in various operating conditions for comparison and analysis purposes, and deviations in these responses are associated with a structural integrity degradation. The system 200 may be mounted onboard the aircraft 1 such that the structural integrity of the tank 30 may be evaluated in real-time while the aircraft 1 is in flight. In other words, the tank 30 may remain installed on the aircraft 1 during the evaluation of its structural integrity. The evaluation of the structural integrity may be performed while the aircraft 1 is flying, or when it is on the ground without requiring disassembling the tank 30. As shown, the tank 30 is secured to surrounding structure via mounts 31, six shown, but any number is contemplated.

The system 200 includes a controller 201 operatively connected to excitors 202 which may be mounted on or proximate to an external surface of the tank 30 for example. The excitors 202 may be non-contact or resonance-type excitors. In the embodiment shown, three excitors 202 are provided on the external surface of the tank 30, but more or less are also contemplated. The excitors 202 may be located at any suitable location. The excitors 202 are configured to induce a stimulus, such as vibrations, to the tank 30. The excitors 202 may be devices operable to generate vibrations, such as, Dirac's impulses, periodic chirps, frequency sweeps, steady-state dwells, and random excitation. The excitors 202 may be mechanical actuators, piezoelectric actuators, and so on. The excitations may be simultaneous or may be phased apart in any specific order. The excitors and response may be indexed in the training data for comparison purposes. The distance between the excitors and sensors may be structure dependent. Prior instrumentation, analysis may be performed to assign excitation and measurement locations. The minimal distance may be dependent on the sensor technology used. The distance between excitor and sensor may be as minimal as combining excitor and sensor, if piezoelectric crystals are being used. These crystals may excite and measure depending on the conditioning circuitry.

The controller 201 is further operatively connected to structural integrity sensors 203, two in this embodiment, but more or less are contemplated, and to operating condition sensors 204, two in this embodiment, but more or less are contemplated. In certain embodiments, the structural integrity sensors 203 are mounted directly against the external surface of the tank 30. The structural integrity sensors 203 may include, for instance, one or more of accelerometers, strain gauges, semiconductor strain gauges, ultrasonic detectors, dynamic pressure transducers, eddy current sensors or any other suitable sensors. The operating condition sensors 204 may include, for instance, one or more of thermocouples, static pressure transducers, liquid level sensors, and so on. The sensors may be static or movable relative to the tank 30. The location of the structural integrity sensors 203 may be selected to be sufficiently far enough from the excitors 202 to ensure that the response measured by the structural integrity sensors 203 is not influenced by the proximity of the excitors.

The system 200 is configured to periodically excite the tank 30 at a plurality of predetermined locations on the tank 30. The structural integrity sensors 203 are used to measure structural responses of the tank 30. The structural integrity sensors 203 may feed signals to the controller 201, the signals indicative of a response of the tank 30 to vibrations induced by the excitors 202. The controller 201 may record those signals as time functions and/or frequency spectrums. The signals may include amplitude, frequency, damping, and phase.

However, the response measured by the structural integrity sensors 203 may be affected by operating and/or environmental conditions. The operating condition sensors 204 are used to obtain data about these operating conditions, including during flight. For instance, the operating conditions may include, a level of a fluid in the tank 30, a temperature of the fluid in the tank 30, a temperature of an environment outside the tank 30, a pressure inside the tank 30, a pressure of the environment outside the tank 30, a level of vibrations of the aircraft or aircraft engine 6 during the measurement of the response with the structural integrity sensors 203, locations of the structural integrity sensors 203, locations of the excitors 202, acceleration of the tank 30 and surrounding structure, and so on. Some of the operating conditions may be part of flight conditions including ambient temperature, altitude, speed, pressurization of the fuselage 2 (Fig. 1), flight dynamics (e.g., pitch, roll, yaw), and so on. The operating conditions may further include rotational speeds of rotors of the aircraft engines 6 (Fig. 1) and vibrations perceived at mount of the aircraft engines 6. All of these operating conditions may affect how the tank 30 will react to the stimulus induced by the excitors 202. The operating conditions may therefore include a series of parameters representative of the conditions in which the tank 30 is subjected to structural integrity evaluations.

It is also possible to measure vibrations induced to the tank 30 during its use before the inducement of the stimulus to factor out these vibrations to isolate the effect of the stimulus on the tank 30. In other words, the tank 30, in use, may be subjected to a baseline level of vibrations resulting from its use while the aircraft 1 is flying, taxiing, etc. Obtaining data about these vibrations will allow the system to isolate the response of the tank 30 to the stimulus while factoring out the other vibrations induced by the aircraft 1 on the tank 30.

The controller 201 includes a trained model 210. The trained model 210 receives the data from the structural integrity sensors 203 and from the operation conditions sensors 204 and compares these measurements to reference data, which may include reference time functions and spectrums. In the embodiment shown, the trained model 210 has been trained with training data 211. Results of the structural integrity evaluation may be displayed on a display 213 operatively connected to the controller 201. The training data may be stored in a database 212, but this may not be the case and may be used solely during a training phase of the trained model 210. Once trained, the trained model 210 may not need access to the training data. However, the training data may be continuously fed with new data as the trained model 210 is used.

The trained model 210 may be configured to compare time signals to characterized damping coefficient; to compare frequency return functions to characterize frequency responses; and to determining damping coefficients at each of the frequencies of the frequency return functions. Adverse conditions in the tank 30 may result in a much different damping of the vibrations compared to a tank devoid of the adverse condition; may present a shift in the frequency return functions such as a structural mode frequency shift; and may present much higher damping at these frequencies.

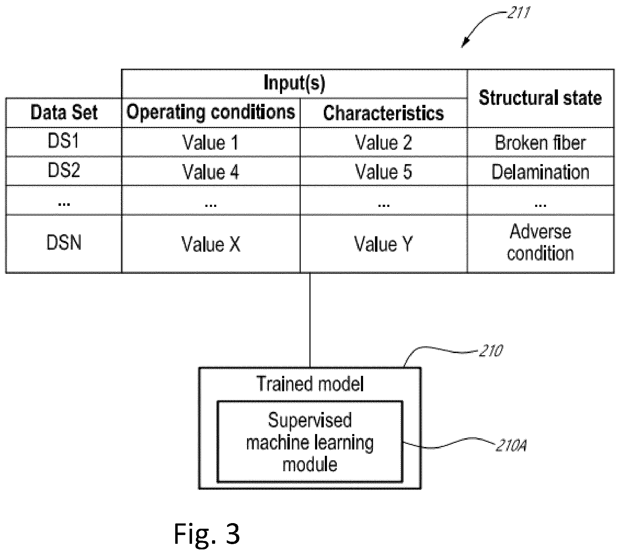

Referring to Fig. 3, the training data 211 is illustrated. The training data 211 includes a plurality of data sets each including characteristic data and operating conditions data associated with structural states data. More specifically, the training data 211 include data obtained from a plethora of structural integrity tests performed on tanks. The conditions of the tests are different from one another in that the tanks were tested in different operating conditions (e.g., temperature, pressure, level of fluid contained in the tank, etc) and parameters of the stimulus provided to the tank were different (e.g., location(s) of the stimulus, parameters of the stimulus, location of the excitors 202, etc). Then, for each test, the structural state of the tanks were assessed using legacy methods to identify if the structural states of the tanks presented adverse conditions such as, for instance, broken fibers, delamination, debonding, cracks in the matrix, wrinkles, resin richness, presence of a foreign object, presence of a void, presence of a blister, porosity, and so on. All of the data gathered from the plurality of tests performed are fed to the trained model 210 which uses a supervised machine learning module 210A to learn how to associate the different operating conditions and characteristics of the response to the structural states of the tanks.

Any suitable type of (e.g., classification) trained model may be constructed according to example embodiments of the present disclosure. For instance, a random forest (RF) model and/or a neural network (NN) model may be constructed. In some embodiments, non-linear regression with or without regularization may be used. In some embodiments, one or more of gradient boost machine, artificial neural network, self-organizing maps, and/or deep learning may be used. In some embodiments, a RF regression model of corrosion and erosion data may be constructed.

In the present embodiment, the trained model 210 may be trained using one or more supervised learning algorithms. Such supervised learning algorithm(s) may build a mathematical model of a set of data that contains both the inputs and the desired outputs. The data is known as training data, and consists of a set of training examples (e.g., data sets). Each training example has one or more inputs and the desired output, also known as a supervisory signal. In the mathematical model, each training example may be represented by an array or vector, sometimes called a feature vector, and the training data is represented by a matrix. Through iterative optimization of an objective function, the supervised learning algorithm(s) may learn a function that can be used to predict the output associated with new inputs. An optimal function may allow the algorithm to correctly determine the output for inputs that were not a part of the training data. An algorithm that improves the accuracy of its outputs or predictions over time is said to have learned to perform that task.

Types of supervised-learning algorithms include active learning, classification and regression. Classification algorithms are used when the outputs are restricted to a limited set of values, and regression algorithms are used when the outputs may have any numerical value within a range. In the present case, a suitable classification algorithm may be used to output a suitable class label (e.g., one of four possible class labels) for the training data 211.

As shown in Fig. 3, the trained model 210 is trained using the training data 211. The training data 211 includes a plurality of data sets identified as "DS1", "DS2" and "DSN". The trained model 211 has a supervised machine learning module 210A that is able to learn how to associate the operating conditions and the characteristics of the response to the stimulus to the structural states of the tanks. By feeding the training data 211 to the supervised machine learning module 210A, the trained model 210 becomes able to recognize the structural state of a tank by receiving data regarding the operating conditions and the characteristics of their response even if said data were not part of the training data 211.

The supervised machine learning module 210A uses supervised learning algorithms by which it builds a mathematical model from a set of data (e.g., training data 211) that contains both the inputs and the desired outputs. Through iterative optimization of an objective function, the supervised machine learning module learns a function that can be used to predict the output associated with new inputs. An optimal function will allow the trained model 210 to correctly determine the output for inputs that were not a part of the training data 211.

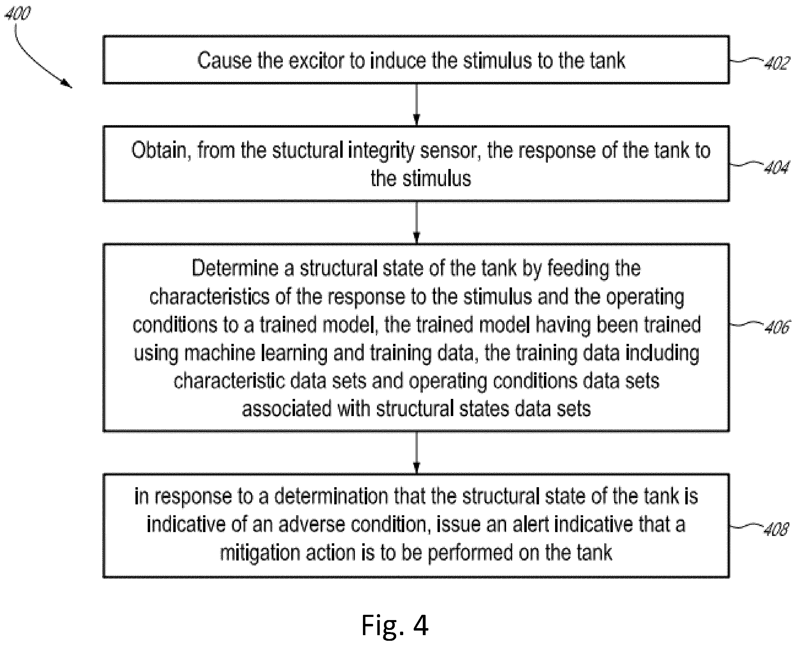

Referring now to Fig. 4, a method to be performed by the controller 201 is shown at 400. The method 400 includes causing the excitor 202 to induce the stimulus to the tank 30 at 402; obtain, from one or more of the sensors, the response of the tank 30 to the stimulus at 404; determine a structural state of the tank by feeding the characteristics of the response to the stimulus and the operating conditions to the trained model 210 at 406. As explained, the trained model 210 has been trained using machine learning and the training data 211 including characteristic data sets and operating conditions data sets associated with structural states data sets. Then, the method 400 includes, in response to a determination that the structural state of the tank 30 is indicative of an adverse condition, issue an alert indicative that a mitigation action is to be performed on the tank 30 at 408. The alert may be a message on the display 213 mitigation, a sound alert, a visual alert, and so on.

In some embodiments, the stimulus is vibrations, the characteristics of the response includes one or more of an amplitude, a frequency, a damping coefficient, and a phase of the response. The characteristics of the response may further include one or more of a structural damping of the response as a function of time, frequency response functions defined as ratios of responses to stimuli as function of stimulation frequencies of the stimuli, and damping coefficients associated with the stimulation frequencies. Orientation of the response may be provided. In some embodiments, time function analysis may be performed since high frequency short duration spikes may be indicators of distress, and more challenging to detect in the frequency domain.

The sensors include at least one structural integrity sensor 203 for sensing the characteristics of the response of the tank 30 to the stimulus. The at least one structural integrity sensor 203 may include one or more of an accelerometer, a strain gauge, a semiconductor strain gauge, an ultrasonic detector, a dynamic pressure transducers, a fiber optic sensor, and an eddy current sensor.

The sensors further include at least one operating condition sensor 204 for sensing the operating conditions of the tank 30. The at least one operating condition sensor 204 may include one or more of a temperature sensor for determining a temperature of the tank, a first pressure sensor for determining a pressure of an environment outside the tank, a second pressure sensor for determining an inside pressure inside the tank, and a level sensor for determining a level of a fluid in the tank.

In some embodiments, the causing of the mitigation action includes one or more of causing a replacement of the tank, scheduling an inspection of the tank, and scheduling a repair procedure to the tank.

The adverse condition may include one or more of broken fibers, delamination, debonding, cracks in the matrix, wrinkles, resin richness, presence of a foreign object, presence of a void, presence of a blister, porosity.

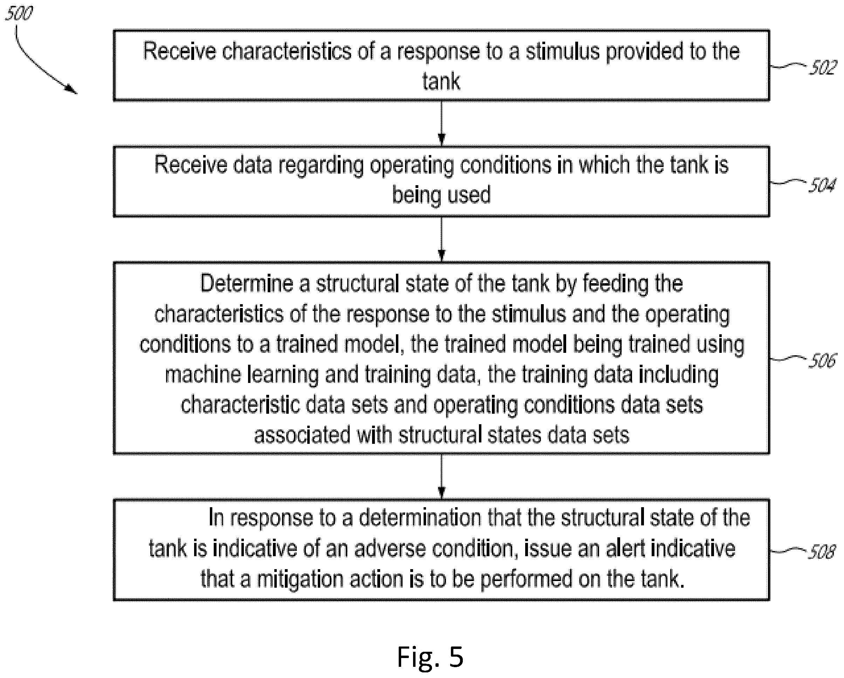

Referring to Fig. 5, a method of mitigating an adverse condition of a structural integrity of the tank 30 is shown at 500. The method 500 includes receiving the characteristics of a response to a stimulus provided to the tank 30 at 502; receiving data regarding the operating conditions in which the tank is being used at 504; determining the structural state of the tank by feeding the characteristics of the response to the stimulus and the operating conditions to the trained model 210 at 506; and in response to a determination that the structural state of the tank 30 is indicative of an adverse condition, issue an alert indicative that a mitigation action is to be performed on the tank 30 at 508.

As previously explained, the stimulus may include vibrations, the receiving of the characteristics of the response includes one or more of an amplitude, a frequency, a damping coefficient, and a phase of the response. The characteristics of the response may further include receiving one or more of a structural damping of the response as a function of time, frequency response functions defined as ratios of responses to stimuli as function of stimulation frequencies of the stimuli, and damping coefficients associated with the stimulation frequencies.

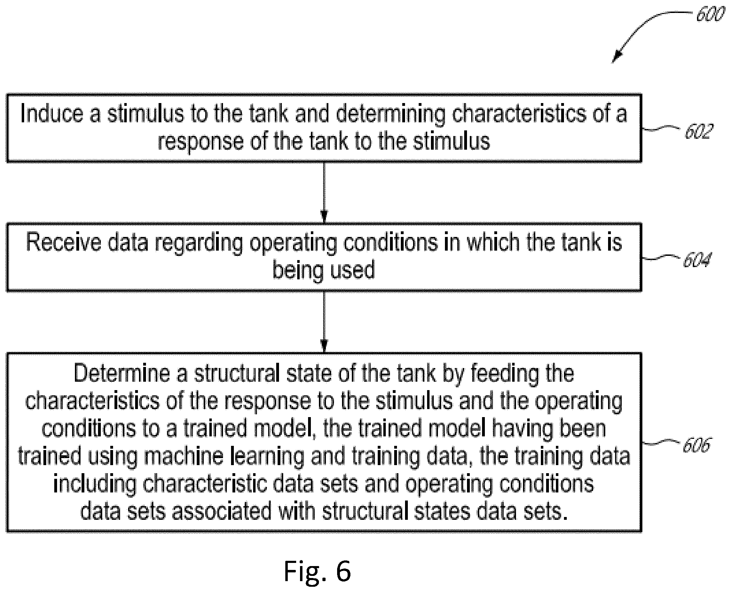

Referring to Fig. 6, a method of evaluating a structural integrity of the tank is shown at 600. The method 600 includes inducing the stimulus to the tank 30 and determining characteristics of the response of the tank 30 to the stimulus at 602; receiving data regarding operating conditions in which the tank 30 is being used at 604; and determining the structural state of the tank 30 by feeding the characteristics of the response to the stimulus and the operating conditions to the trained model 210 at 606.

The steps of the methods 400, 500 described above with reference to Figs. 4 and 5 may be performed when executing the method 600 of Fig. 6.

The methods disclosed herein may be used for end of line quality inspection of composite tanks to detect anomalies like porosity, blisters, blow-holes, foreign-object capture, and reticulation issues.

The training data 211 may be continuously fed with new data obtained from testing perform on tanks 30 of aircraft. This may allow to quantify defects and determine or refine decision algorithms on structural integrity. The learning may be iterative and may be shared through a fleet network for evolutive comparison with additional samples.

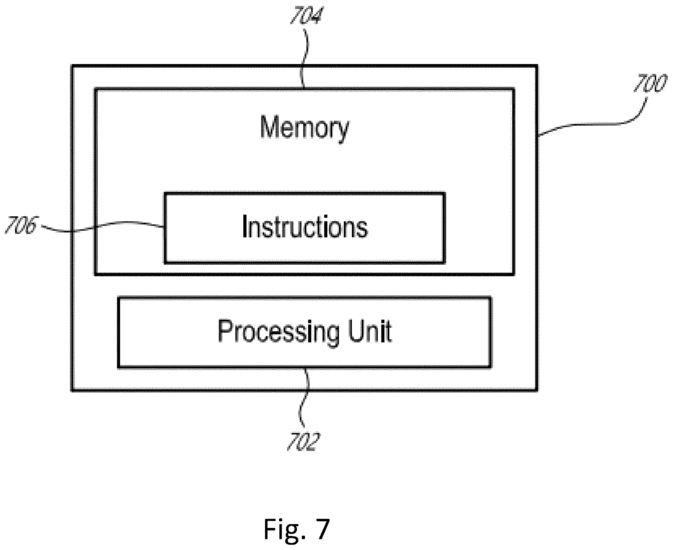

With reference to Fig. 7, an example of a computing device 700 is illustrated. For simplicity only one computing device 700 is shown but the system may include more computing devices 700 operable to exchange data. The computing devices 700 may be the same or different types of devices. The controller 201 may be implemented with one or more computing devices 700. Note that the controller 201 can be implemented as part of a full-authority digital engine controls (FADEC) or other similar device, including electronic engine control (EEC), engine control unit (ECU), electronic propeller control, propeller control unit, and the like. In some embodiments, the controller 201 is implemented as a Flight Data Acquisition Storage and Transmission system, such as a FAST^{™} system. The controller 201 may be implemented in part in the FAST^{™} system and in part in the EEC. Other embodiments may also apply.

The computing device 700 comprises a processing unit 702 and a memory 704 which has stored therein computer-executable instructions 706. The processing unit 702 may comprise any suitable devices configured to implement the methods described herein such that instructions 706, when executed by the computing device 700 or other programmable apparatus, may cause the functions/acts/steps performed as part of the methods described herein as described herein to be executed. The processing unit 702 may comprise, for example, any type of general-purpose microprocessor or microcontroller, a digital signal processing (DSP) processor, a central processing unit (CPU), an integrated circuit, a field programmable gate array (FPGA), a reconfigurable processor, other suitably programmed or programmable logic circuits, or any combination thereof.

The memory 704 may comprise any suitable known or other machine-readable storage medium. The memory 704 may comprise non-transitory computer readable storage medium, for example, but not limited to, an electronic, magnetic, optical, electromagnetic, infrared, or semiconductor system, apparatus, or device, or any suitable combination of the foregoing. The memory 704 may include a suitable combination of any type of computer memory that is located either internally or externally to device, for example random-access memory (RAM), read-only memory (ROM), compact disc read-only memory (CDROM), electro-optical memory, magnetooptical memory, erasable programmable read-only memory (EPROM), and electrically-erasable programmable read-only memory (EEPROM), Ferroelectric RAM (FRAM) or the like. Memory 704 may comprise any storage means (e.g., devices) suitable for retrievably storing machine-readable instructions 706 executable by processing unit 702.

The methods and systems described herein may be implemented in a high level procedural or object oriented programming or scripting language, or a combination thereof, to communicate with or assist in the operation of a computer system, for example the computing device 700. Alternatively, the methods and systems described herein may be implemented in assembly or machine language. The language may be a compiled or interpreted language. Program code for implementing the methods and systems described herein may be stored on a storage media or a device, for example a ROM, a magnetic disk, an optical disc, a flash drive, or any other suitable storage media or device. The program code may be readable by a general or special-purpose programmable computer for configuring and operating the computer when the storage media or device is read by the computer to perform the procedures described herein. Embodiments of the methods and systems described herein may also be considered to be implemented by way of a non-transitory computer-readable storage medium having a computer program stored thereon. The computer program may comprise computer-readable instructions which cause a computer, or more specifically the processing unit 702 of the computing device 700, to operate in a specific and predefined manner to perform the functions described herein, for example those described in the methods described herein.

Computer-executable instructions may be in many forms, including program modules, executed by one or more computers or other devices. Generally, program modules include routines, programs, objects, components, data structures, etc., that perform particular tasks or implement particular abstract data types. Typically the functionality of the program modules may be combined or distributed as desired in various embodiments.

The embodiments described herein are implemented by physical computer hardware, including computing devices, servers, receivers, transmitters, processors, memory, displays, and networks. The embodiments described herein provide useful physical machines and particularly configured computer hardware arrangements. The embodiments described herein are directed to electronic machines and methods implemented by electronic machines adapted for processing and transforming electromagnetic signals which represent various types of information. The embodiments described herein pervasively and integrally relate to machines, and their uses; and the embodiments described herein have no meaning or practical applicability outside their use with computer hardware, machines, and various hardware components. Substituting the physical hardware particularly configured to implement various acts for non-physical hardware, using mental steps for example, may substantially affect the way the embodiments work. Such computer hardware limitations are clearly essential elements of the embodiments described herein, and they cannot be omitted or substituted for mental means without having a material effect on the operation and structure of the embodiments described herein. The computer hardware is essential to implement the various embodiments described herein and is not merely used to perform steps expeditiously and in an efficient manner.

The term "connected" or "coupled to" may include both direct coupling (in which two elements that are coupled to each other contact each other) and indirect coupling (in which at least one additional element is located between the two elements).

The technical solution of embodiments may be in the form of a software product. The software product may be stored in a non-volatile or non-transitory storage medium, which can be a compact disk read-only memory (CD-ROM), a USB flash disk, or a removable hard disk. The software product includes a number of instructions that enable a computer device (personal computer, server, or network device) to execute the methods provided by the embodiments.

It is noted that various connections are set forth between elements in the preceding description and in the drawings. It is noted that these connections are general and, unless specified otherwise, may be direct or indirect and that this specification is not intended to be limiting in this respect. A coupling between two or more entities may refer to a direct connection or an indirect connection. An indirect connection may incorporate one or more intervening entities. The term "connected" or "coupled to" may therefore include both direct coupling (in which two elements that are coupled to each other contact each other) and indirect coupling (in which at least one additional element is located between the two elements).

It is further noted that various method or process steps for embodiments of the present disclosure are described in the preceding description and drawings. The description may present the method and/or process steps as a particular sequence. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the description should not be construed as a limitation.

Furthermore, no element, component, or method step in the present disclosure is intended to be dedicated to the public regardless of whether the element, component, or method step is explicitly recited in the claims. As used herein, the terms "comprises", "comprising", or any other variation thereof, are intended to cover a non-exclusive inclusion, such that a process, method, article, or apparatus that comprises a list of elements does not include only those elements but may include other elements not expressly listed or inherent to such process, method, article, or apparatus.

While various aspects of the present disclosure have been disclosed, it will be apparent to those of ordinary skill in the art that many more embodiments and implementations are possible within the scope of the present disclosure. For example, the present disclosure as described herein includes several aspects and embodiments that include particular features. Although these particular features may be described individually, it is within the scope of the present disclosure that some or all of these features may be combined with any one of the aspects and remain within the scope of the present disclosure. References to "various embodiments," "one embodiment," "an embodiment," "an example embodiment," etc., indicate that the embodiment described may include a particular feature, structure, or characteristic, but every embodiment may not necessarily include the particular feature, structure, or characteristic. Moreover, such phrases are not necessarily referring to the same embodiment. The use of the indefinite article "a" as used herein with reference to a particular element is intended to encompass "one or more" such elements, and similarly the use of the definite article "the" in reference to a particular element is not intended to exclude the possibility that multiple of such elements may be present.

The embodiments described in this document provide non-limiting examples of possible implementations of the present technology. Upon review of the present disclosure, a person of ordinary skill in the art will recognize that changes may be made to the embodiments described herein without departing from the scope of the present invention as defined by the appended claims.

## Claims

1. A structural integrity evaluation system for a tank made of a composite material, the composite material including fibers embedded in a matrix, comprising:
an excitor operatively connected to the tank and configured for inducing a stimulus to the tank;
sensors operatively connected to the tank, the sensors including a structural integrity sensor for sensing characteristics of a response of the tank to the stimulus generated by the excitor and an operating condition sensor for sensing operating conditions in which the tank is being used;
a controller operatively connected to the excitor and to the sensors, the controller having a processing unit and a computer-readable medium having stored thereon instructions executable by the processing unit to:
cause the excitor to induce the stimulus to the tank;
obtain, from the structural integrity sensor, the response of the tank to the stimulus;
determine a structural state of the tank by feeding the characteristics of the response to the stimulus and the operating conditions to a trained model, the trained model having been trained using machine learning and training data, the training data including characteristic data sets and operating conditions data sets associated with structural states data sets; and
in response to a determination that the structural state of the tank is indicative of an adverse condition, issue an alert indicative that a mitigation action is to be performed on the tank.

2. The structural integrity evaluation system of claim 1, wherein the stimulus includes vibrations, the characteristics of the response includes one or more of an amplitude, a frequency, a damping coefficient, and a phase of the response.

3. The structural integrity evaluation system of claim 2, wherein the characteristics of the response further include one or more of a structural damping of the response as a function of time, frequency response functions defined as ratios of responses to stimuli as function of stimulation frequencies of the stimuli, and damping coefficients associated with the stimulation frequencies.

4. The structural integrity evaluation system of any of the preceding claims, wherein the sensors include at least one structural sensor for sensing the characteristics of the response of the tank to the stimulus, the at least one structural sensor including one or more of an accelerometer, a strain gauge, a semiconductor strain gauge, an ultrasonic detector, a dynamic pressure transducers, and an eddy current sensor.

5. The structural integrity evaluation system of any of the preceding claims, wherein the sensors include at least one operating condition sensor for sensing the operating conditions of the tank, the at least one operating condition sensor including one or more of a temperature sensor for determining a temperature of the tank, a first pressure sensor for determining a pressure of an environment outside the tank, a second pressure sensor for determining an inside pressure inside the tank, and a level sensor for determining a level of a fluid in the tank.

6. The structural integrity evaluation system of any of the preceding claims, wherein mitigation action is one or more of a replacement of the tank, an inspection of the tank, and a repair procedure to the tank.

7. The structural integrity evaluation system of any of the preceding claims, wherein the computer-readable medium further has instructions executable by the processing unit to determine that the structural state of the tank is indicative of the adverse condition by determining that the structural state presents one or more of broken fibers, delamination, debonding, cracks in the matrix, wrinkles, resin richness, presence of a foreign object, presence of a void, presence of a blister, porosity.

8. An aircraft comprising the tank and the structural integrity evaluation system of any of the preceding claims, wherein the computer-readable medium further has instructions executable by the processing unit to determine the structural state of the tank while the tank is installed on the aircraft.

9. A method of mitigating an adverse condition of a structural integrity of a tank made of a composite material including fibers embedded in a matrix, comprising:
receiving characteristics of a response to a stimulus provided to the tank;
receiving data regarding operating conditions in which the tank is being used;
determining a structural state of the tank by feeding the characteristics of the response to the stimulus and the operating conditions to a trained model, the trained model having been trained using machine learning and training data, the training data including characteristic data sets and operating conditions data sets associated with structural states data sets; and
in response to a determination that the structural state of the tank is indicative of an adverse condition, issue an alert indicative that a mitigation action is to be performed on the tank.

10. The method of claim 9, wherein: the stimulus includes vibrations, the receiving of the characteristics of the response includes one or more of an amplitude, a frequency, a damping coefficient, and a phase of the response; and optionally wherein the receiving of the characteristics of the response further includes receiving one or more of a structural damping of the response as a function of time, frequency response functions defined as ratios of responses to stimuli as function of stimulation frequencies of the stimuli, and damping coefficients associated with the stimulation frequencies.

11. The method of claim 9 or 10, wherein the receiving of the characteristics of the response includes receiving the characteristics of the response from at least one structural sensor, the at least one structural sensor including one or more of an accelerometer, a strain gauge, a semiconductor strain gauge, an ultrasonic detector, a dynamic pressure transducer, a fiber optic sensor, and an eddy current sensor.

12. The method of any one of claims 9 to 11, wherein the receiving of the data regarding the operating conditions includes receiving the data from at least one operating condition sensor, the at least one operating condition sensor including one or more of a temperature sensor for determining a temperature of the tank, a first pressure sensor for determining a pressure of an environment outside the tank, a second pressure sensor for determining an inside pressure inside the tank, and a level sensor for determining a level of a fluid in the tank.

13. The method of any one of claims 9 to 12, comprising causing of the mitigation action to be performed on the tank by one or more of causing a replacement of the tank, scheduling an inspection of the tank, and scheduling a repair procedure to the tank.

14. The method of any one of claims 9 to 13, wherein the determining that the structural state of the tank is indicative of the adverse condition includes determining that the structural state presents one or more of broken fibers, delamination, debonding, cracks in the matrix, wrinkles, resin richness, presence of a foreign object, presence of a void, presence of a blister, porosity.

15. A method of evaluating a structural integrity of a tank made of a composite material including fibers embedded in a matrix, comprising:
inducing a stimulus to the tank and determining characteristics of a response of the tank to the stimulus;
receiving data regarding operating conditions in which the tank is being used; and
determining a structural state of the tank by feeding the characteristics of the response to the stimulus and the operating conditions to a trained model, the trained model having been trained using machine learning and training data, the training data including characteristic data sets and operating conditions data sets associated with structural states data sets.
